# FASCICULE DE BREVET EUROPEEN

(11) **EP 1 616 387 B1**
(45) Date de publication et mention de la délivrance du brevet: **19.08.2009**
(21) Numéro de dépôt: 04742563.2
(22) Date de dépôt: 22.04.2004
(51) Int. Cl.: H03K 5/08, G01R 31/02

(54) **ETAGE D'ENTREE D'UNE UNITE DE TRAITEMENT DE SIGNAL**
EINGANGSSTUFE EINER SIGNALVERARBEITUNGSEINHEIT
INPUT STAGE OF A PROCESSING UNIT

(30) Priorité: 24.04.2003 FR 0305033
(43) Date de publication de la demande: 18.01.2006
(73) Titulaire: Honeywell, 91190 Saint Aubin (FR)
(72) Inventeur: CARNICELLI, Vito, F-38170 Seyssinet Pariset (FR); LENOIR, Jean-Christophe, F-38410 Vaulnaveys Le Haut (FR); SIMON, Jean-Luc, F-38100 Grenoble (FR); BOUTEILLE, Jean-Michel, F-38770 La Motte d'Aveillans (FR)
(74) Mandataire: Jouvray, Marie-Andrée
(86) Numéro de dépôt international: PCT/FR2004/000988
(87) Numéro de publication internationale: WO 2004/098056

(56) Documents cités:
- EP-A- 0 556 549
- DE-A- 3 104 548
- FR-A- 2 631 129
- GB-A- 2 195 846
- US-A- 5 216 674

## Description

### Domaine technique de l'invention

L'invention concerne un étage d'entrée d'une unité de traitement, comportant un circuit de traitement connecté à l'étage d'entrée. L'étage d'entrée est destiné à être connecté à un étage de sortie d'un capteur ou d'un automate.

### État de la technique

L'étage d'entrée d'une unité de traitement doit être adapté aux sorties des circuits disposés en amont. En effet, une unité de traitement reçoit, par exemple, des signaux en provenance de capteurs ou d'automates, dont les étages de sortie comportent fréquemment des commutateurs, par exemple des transistors, ou des contacts de sortie de relais électromécaniques. Actuellement, l'étage d'entrée d'une unité de traitement comporte généralement des entrées adaptées à un type de sortie prédéterminée. Certains comportent des entrées qui, moyennant un câblage particulier, permettent d'accueillir une sortie capteur ou automate d'un premier type (transistor PNP) ou une sortie d'un second type (transistor NPN). D'autres étages d'entrée comportent un sélecteur interne permettant de l'adapter à un type de sortie prédéterminé. Tous les étages d'entrée actuels nécessitent deux ou trois fils de liaison entre l'unité de traitement et une sortie de capteur ou d'automate

De nombreuses unités de traitement, notamment décrites dans le document EP-A-556549 et dans le brevet US 5216674, adaptées au traitement de signaux en provenance de réseaux de transmission de données et devant, en conséquence, traiter des débits importants, ne sont pas utilisables en milieu industriel.

### Objet de l'invention

L'invention a pour but de surmonter les inconvénients des étages de sortie connus et, plus particulièrement, d'utiliser, en milieu industriel, un même étage d'entrée, sans nécessiter de configuration additionnelle, quel que soit le type de sortie qui lui est connecté. L'étage d'entrée selon l'invention doit notamment permettre de ne connecter qu'un seul fil entre la sortie d'un capteur industriel, capteur ou automate, indépendamment de son type de sortie, et l'unité de traitement.

Selon l'invention, ce but est atteint par les revendications annexées et plus particulièrement par le fait qu'il comporte des moyens de polarisation d'une entrée de l'étage d'entrée, à une tension de polarisation correspondant à une fraction prédéterminée d'une tension d'alimentation, et des moyens de filtrage disposés entre l'entrée polarisée et des moyens de comparaison de la tension de l'entrée polarisée de l'étage d'entrée à au moins deux seuils de tension, respectivement supérieur et inférieur à la tension de polarisation, de manière à fournir au moins 2 bits au circuit de traitement.

### Description sommaire des dessins

D'autres avantages et caractéristiques ressortiront plus clairement de la description qui va suivre de modes particuliers de réalisation de l'invention, donnés à titre d'exemples non limitatifs et représentés aux dessins annexés, dans lesquels :
Les figures 1 et 2 représentent une unité de traitement comportant un étage d'entrée selon l'invention, respectivement associé à un capteur comportant en sortie respectivement des transistors de type PNP et NPN.
Les figures 3 et 4 représentent deux autres sorties de capteurs pouvant être connectées à un étage d'entrée selon l'invention.
Les figures 5 à 8 illustrent les signaux en divers points du circuit de traitement selon les figures 1 et 2.
La figure 9 représente une variante du circuit de comparaison d'un étage d'entrée selon l'invention.

### Description de modes particuliers de réalisation.

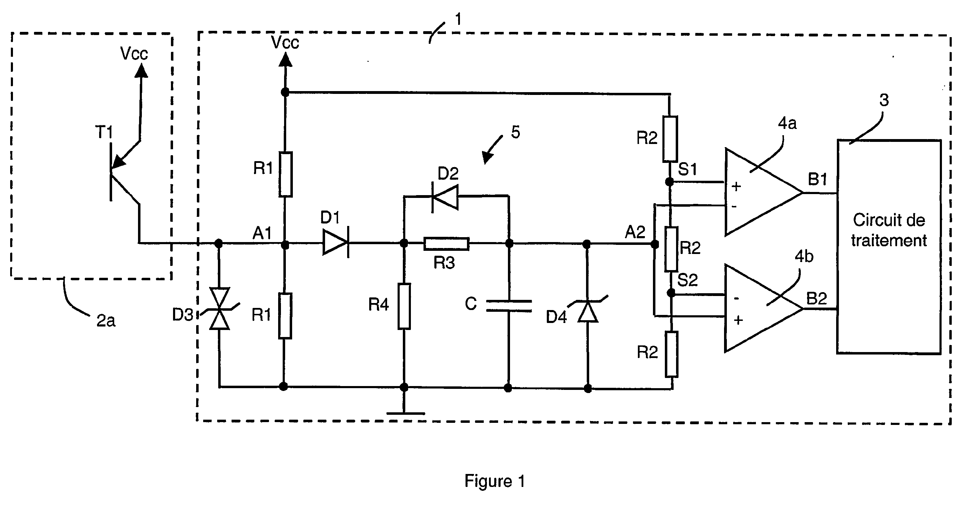

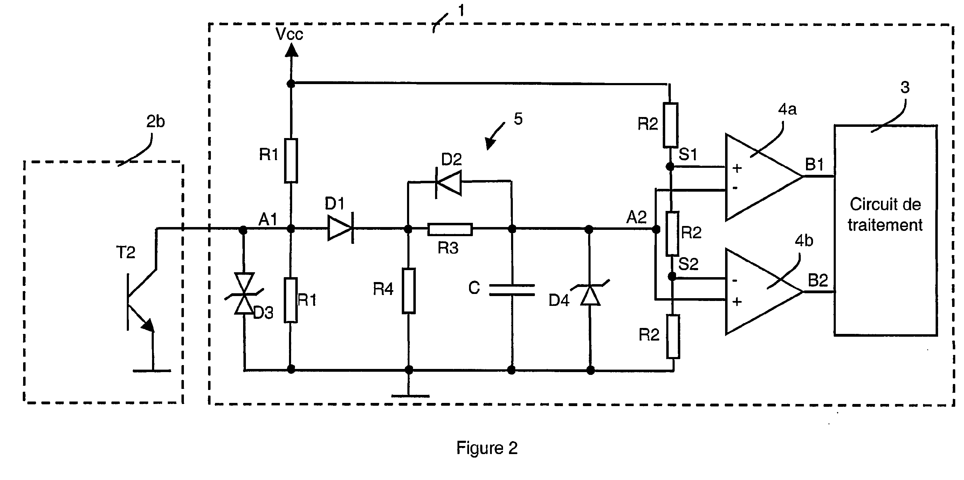

Dans les modes particuliers de réalisation représentés sur les figures 1 et 2, une même entrée A1 d'un étage d'entrée d'une unité de traitement 1 peut être connectée indifféremment à un capteur 2a (figure 1) ou à un capteur 2b (figure 2). L'étage de sortie du capteur 2a comporte un transistor de sortie T1, de type PNP, connecté entre une tension d'alimentation Vcc et une sortie du capteur, destinée à être connectée à l'entrée A1, tandis que l'étage de sortie du capteur 2b comporte un transistor de sortie T2, de type NPN, connecté entre la masse et une sortie du capteur, destinée à être connectée à l'entrée A1. Les capteurs 2, de type classique, ne sont pas représentés plus en détail, seul l'étage de sortie jouant un rôle dans la présente invention.

L'unité de traitement 1 comporte un étage d'entrée connecté à un circuit de traitement 3. Sur les figures 1 et 2, l'entrée A1 de l'étage d'entrée de l'unité de traitement est connectée à une électrode de mesure constituée par le collecteur du transistor de sortie du capteur 2. L'entrée A1 est polarisée, par exemple par un diviseur résistif, à une tension de polarisation prédéterminée. Sur les figures 1 et 2, le diviseur résistif est constitué par deux résistances R1, de même valeur, connectées en série entre une tension d'alimentation Vcc et la masse. Le point A1, qui est commun aux deux résistances R1 et constitue l'entrée de l'étage d'entrée de l'unité de traitement 1, est ainsi polarisé à une tension Vcc/2.

Dans l'étage d'entrée, l'entrée A1 est connectée à des premières entrées A2 de deux comparateurs 4a et 4b d'un circuit de comparaison. Des première et seconde tensions de référence, définissant deux seuils de tension S1 et S2, sont respectivement appliquées à des secondes entrées des comparateurs 4a et 4b. Le premier seuil de tension S1 est compris entre la tension de polarisation Vcc/2 et la tension d'alimentation Vcc, tandis que le second seuil de tension S2 est compris entre la masse et la tension de polarisation Vcc/2. Dans le mode de réalisation particulier illustré sur les figures 1 et 2, les tensions de référence sont obtenues au moyen d'un diviseur résistif constitué par trois résistances R2, de valeurs identiques, connectées en série entre la tension d'alimentation Vcc et la masse. Ce diviseur résistif définit ainsi les deux seuils de tension S1 et S2, respectivement égaux à 2Vcc/3 et Vcc/3, en des points respectivement constitués par les points communs à deux résistances R2 adjacentes.

Les comparateurs 4a et 4b fournissent chacun un bit, respectivement B1 et B2, au circuit de traitement 3 pour lui permettre de reconnaître le type de sortie connectée à l'entrée A1 et l'état haut ou bas de cette sortie. Dans le mode particulier de réalisation représenté aux figures 1 et 2, le point A2 est connecté à l'entrée négative du comparateur 4a et à l'entrée positive du comparateur 4b, tandis que les tensions de référence S1 et S2, sont respectivement appliquées à l'entrée positive du comparateur 4a et à l'entrée négative du comparateur 4b.

Les bits B1 et B2 prennent alors les valeurs suivantes en fonction de la tension VA2 au point A2, qui est représentative de la tension VA1 à l'entrée A1 :
- B1=1 et B2=0, lorsque la tension VA2 est inférieure ou égale à S2.
- B1=B2=1, lorsque la tension VA2 est comprise entre S2 et S1.
- B1=0 et B2=1, lorsque la tension VA2 est supérieure ou égale à S1.

Un filtre 5 est disposé entre l'entrée A1 et les premières entrées des comparateurs 4a et 4b (point A2). Sur les figures 1 et 2, l'entrée A1 est connectée au filtre 5 par une diode D1, polarisée en direct. Le filtre 5 comporte, par exemple, une résistance R3, connectée en série avec la diode D1 entre l'entrée A1 et le point A2, une résistance R4, connectée entre la cathode de la diode D1 (point commun à D1 et R3) et la masse, un condensateur C, connecté entre le point A2 et la masse, et une diode D2 permettant la symétrie du filtrage, connectée en inverse, en parallèle sur la résistance R3. Les valeurs respectives des différents éléments du filtre 5 sont choisies en fonction des fonctions associées à l'entrée A1.

La constante de temps du filtre 5 est supérieure à quelques millisecondes, par exemple supérieure à 10ms, pour assurer un temps de réponse suffisamment rapide tout en maintenant une immunité minimale aux parasites industriels (rebonds de contacts de relais, parasites électriques...), sans interférer sur la transmission des signaux en provenance des capteurs ou des automates, qui sont classiquement des signaux à variation lente. Elle peut être courte, de préférence de l'ordre de 20ms, ou plus élevée, par exemple de l'ordre de 50ms, pour assurer une très bonne immunité aux parasites conduits, et de l'ordre de 100ms lorsque l'entrée est associée à des contacteurs, de manière à tenir compte des rebonds éventuels des contacteurs.

Sur les figures 1 et 2, une diode D3, de type Transil, bidirectionnelle, connectée entre l'entrée A1 et la masse assure, avec une diode Zener D4, connectée entre le point A2 et la masse, la protection contre les transitoires rapides et les ondes de choc. Ceci permet de garantir une protection optimale face au parasitage et une bonne tolérance vis-à-vis d'une tension d'alimentation mal régulée.

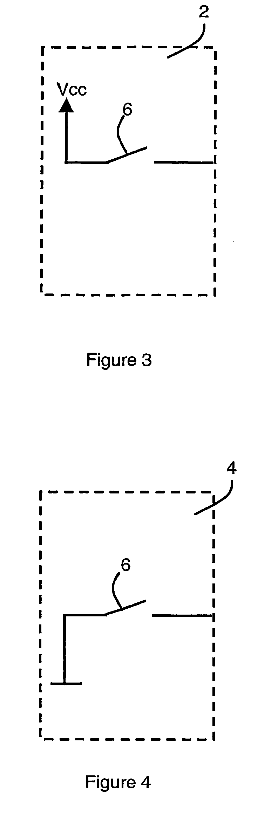

L'entrée A1 de l'unité de traitement des figures 1 et 2 peut être connectée non seulement à des sorties de type PNP ou NPN, mais également à tout type de sorties de capteur ou d'automate, c'est-à-dire à tout type de capteur industriel. Elle peut, par exemple, être connectée à des sorties comportant, comme représenté aux figures 3 et 4, un commutateur ou un contact 6 de relais électromagnétique dont une borne est connectée à la sortie du capteur, qui est destinée à être connectée à l'entrée A1, et dont l'autre borne est connectée, dans le capteur 2, soit à la tension d'alimentation Vcc (figure 3), soit à la masse (figure 4). Les deux bits (B1, B2) de sortie du circuit de comparaison sont alors représentatifs du type de connexion du contact et de son état.

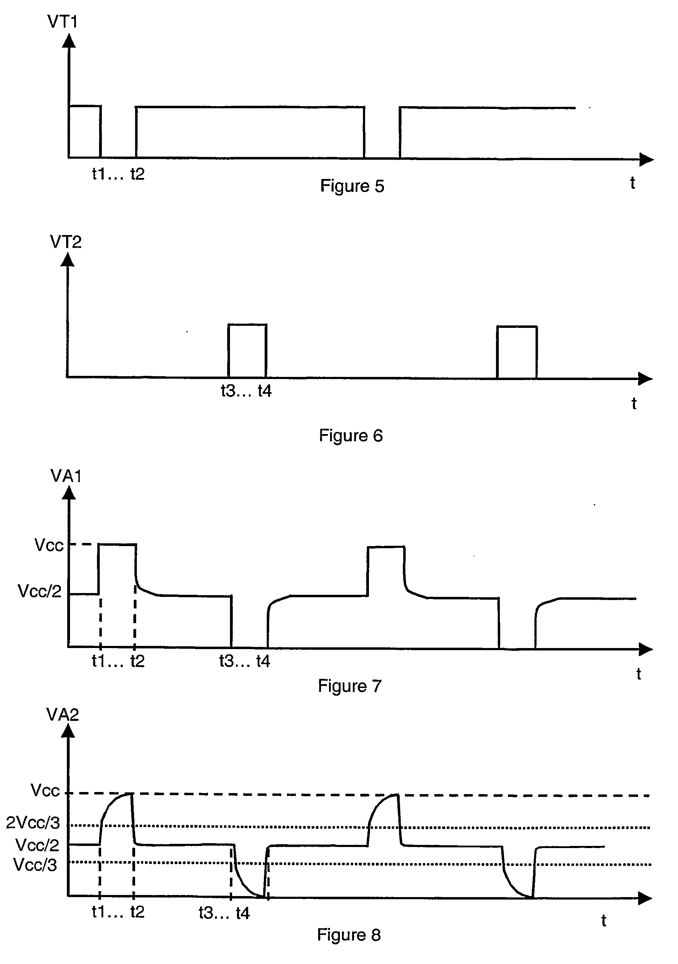

Le fonctionnement de l'unité de traitement 1 va être explicité en référence aux figures 1, 2 et 5 à 8. Les figures 5 et 6 illustrent respectivement, en fonction du temps, les signaux VT1 et VT2 de commande des transistors T1 et T2, tandis que les figures 7 et 8 représentent respectivement, en fonction du temps, les tensions VA1 et VA2 à l'entrée A1 et au point A2, respectivement avant et après filtrage par le filtre 5, d'un étage d'entrée d'une unité de traitement 1 dont l'entrée A1 serait connectée à la fois à un transistor T1 et à un transistor T2.

Lorsque le transistor de sortie T1 d'un capteur 2a est activé, entre les instants t1 et t2, la tension VT1, normalement à une valeur binaire 1 (par exemple Vcc), passe à zéro. Le transistor T1 devient alors conducteur et la tension VA1 à l'entrée A1 de l'unité de traitement connecté au collecteur du transistor T1, normalement polarisée à Vcc/2, prend la valeur de la tension d'alimentation Vcc. Après filtrage, la tension VA2, normalement à Vcc/2, passe également à Vcc.

Par contre, lorsque le transistor de sortie T2 d'un capteur 2b est activé, entre les instants t3 et t4, la tension VT2, normalement à zéro, passe à une valeur binaire 1 (par exemple Vcc). Le transistor T2 devient alors conducteur et la tension VA1 à l'entrée A1 de l'unité de traitement connectée au collecteur du transistor T2, normalement polarisée à Vcc/2, passe à zéro. Après filtrage, la tension VA2, normalement à Vcc/2, passe également à zéro.

La tension VA2 est comparée aux seuils de tension S1 et S2, respectivement égaux à 2Vcc/3 et Vcc/3, respectivement par les comparateurs 4a et 4b. Il est ainsi possible de différencier, à la sortie des comparateurs 4a et 4b, les 3 valeurs possibles de la tension VA2:
- lorsque ni le transistor T1, ni le transistor T2 ne sont activés ou lorsque aucun capteur n'est connecté à l'entrée A1 (capteur absent), la tension VA2 est comprise entre Vcc/3 et 2Vcc/3 (avant t1, entre t2 et t3 et après t4) et B1=B2=1,
- lorsqu'un transistor T1, de type PNP, est activé, la tension VA2 est supérieure ou égale à 2Vcc/3 (entre t1 et t2), B1=0 et B2=1,
- lorsqu'un transistor T2, de type NPN, est activé, la tension VA2 est inférieure ou égale à Vcc/3 (entre t3 et t4), B1=1 et B2=0.

Si B1=B2=0, cela signifie que l'étage d'entrée lui-même et plus particulièrement le circuit de comparaison, qui constitue un convertisseur analogique-numérique, est défaillant.

L'analyse des bits de sortie B1 et B2 des comparateurs 4a et 4b par le circuit de traitement 3 permet ainsi non seulement d'analyser les signaux, à variation lente, transmis par les capteurs, mais également de reconnaître automatiquement une défaillance et le type de transistor de sortie connecté à l'entrée A1 lorsque ce transistor est activé. Il est ainsi possible de diviser par deux le nombre d'entrées d'un étage d'entrée, tout en ne nécessitant qu'un seul fil entre l'unité de traitement 1 et un capteur 2 ou un automate, indépendamment du type d'étage de sortie du capteur ou de l'automate.

En cas de problème sur la ligne par laquelle passe les signaux à analyser, en amont du point A2, par exemple en cas de court-circuit, la tension VA2 est mise à la masse ou prend la valeur Vcc et un bit de sortie des comparateurs 4a et 4b reste constamment à la valeur binaire 1, tandis que l'autre reste constamment à la valeur binaire 0. Le circuit de traitement 3 peut ainsi vérifier l'état de la ligne en amont du point A2.

Chaque entrée A1 d'une unité de traitement 1 pouvant être connecté à deux types de sorties, l'invention permet de diviser par deux le nombre d'entrées de l'unité de traitement et, en conséquence d'augmenter sa flexibilité pour un faible surcoût.

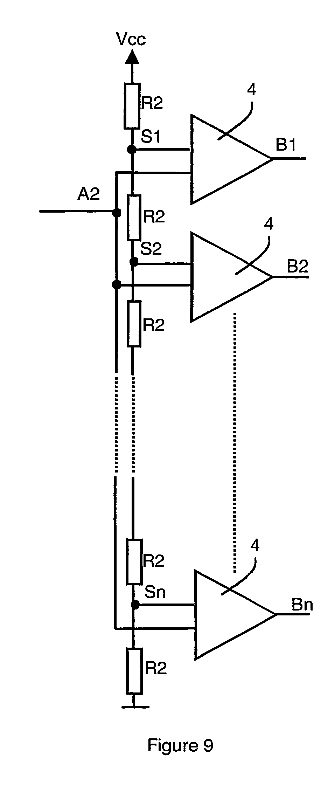

Dans une variante de réalisation illustrée à la figure 9, le circuit de comparaison de l'étage d'entrée comporte n comparateurs 4 ayant chacun une première entrée connectée au point A2. Un nombre n de tensions de référence, définissant n seuils de tension S1 à Sn, sont respectivement appliquées à des secondes entrées des n comparateurs 4.

Dans le mode de réalisation particulier illustré sur la figure 9, les n tensions de référence sont obtenues au moyen d'un diviseur résistif constitué par n+1 résistances R2, de valeurs identiques, connectées en série entre la tension d'alimentation Vcc et la masse. Ce diviseur résistif définit ainsi les n seuils de tension S1 à Sn en des points respectivement constitués par les points communs à deux résistances R2 adjacentes. Les n comparateurs 4 fournissent chacun un bit, respectivement B1 à Bn, au circuit de traitement 3. Un tel circuit a la fonction d'un convertisseur analogique-numérique sur n bits. Un étage d'entrée d'une unité de traitement comportant un tel circuit de comparaison permet au circuit de traitement 3 de surveiller des capteurs, fournissant des signaux analogiques à variation lente et connectés à l'entrée A1, à partir des n bits qui lui sont fournis par le circuit de comparaison. En effet, les bits B1 à Bn sont alors représentatifs des signaux de sortie du capteur industriel connecté à l'entrée A1. Il est également possible d'analyser ainsi plus finement une dégradation progressive du capteur, par exemple une augmentation des fuites, et de provoquer, de préférence avant défaillance, le déclenchement d'une alarme et/ou un arrêt d'urgence, de manière à assurer la sécurité d'une installation.

L'étage d'entrée selon l'invention permet ainsi d'assurer à la fois la sécurité et la disponibilité d'une installation comportant des capteurs industriels.

## Revendications

1. Étage d'entrée d'une unité de traitement, comportant un circuit de traitement (3), étage d'entrée destiné à être connecté à un étage de sortie d'un capteur ou d'un automate et **caractérisé en ce qu'**il comporte des moyens de polarisation d'une entrée (A1) de l'étage d'entrée, à une tension de polarisation correspondant à une fraction prédéterminée d'une tension d'alimentation (Vcc), et des moyens de filtrage (5) disposés entre l'entrée polarisée (A1) et des moyens de comparaison de la tension de l'entrée (A1) polarisée de l'étage d'entrée à au moins deux seuils de tension (S1, S2), respectivement supérieur et inférieur à la tension de polarisation, de manière à fournir au moins 2 bits (B1, B2) au circuit de traitement (3).

2. Étage d'entrée selon la revendication 1, **caractérisé en ce que** la tension de polarisation (Vcc/2) est sensiblement égale à la moitié de la tension d'alimentation (Vcc).

3. Étage d'entrée selon l'une des revendications 1 et 2, **caractérisé en ce que** les moyens de comparaison comportent deux seuils de tension (S1, S2) et fournissent deux bits de sortie représentatifs du type d'étage de sortie connecté à ladite entrée (A1) de l'unité de traitement et de son état.

4. Étage d'entrée selon l'une quelconque des revendications 1 à 3, **caractérisé en ce que,** l'étage de sortie du capteur ou de l'automate comportant un transistor de sortie (T1, T2) ayant une électrode de mesure connectée à l'entrée (A1) polarisée de l'étage d'entrée de l'unité de traitement, les bits de sortie des moyens de comparaison de l'étage d'entrée sont représentatifs du type de transistor de sortie et de son état.

5. Étage d'entrée selon la revendication 4, **caractérisé en ce que** le transistor de sortie est de type PNP ou NPN.

6. Étage d'entrée selon l'une quelconque des revendications 1 à 3, **caractérisé en ce que,** l'étage de sortie du capteur ou de l'automate comportant un contact de relais électromagnétique connecté à la masse ou à la tension d'alimentation, les deux bits de sortie des moyens de comparaison sont représentatifs du type de connexion du contact et de son état.

7. Étage d'entrée selon l'une quelconque des revendication 1 à 6, **caractérisé en ce que** les premier et second seuils de tension sont respectivement de l'ordre des 2/3 et du tiers de la tension d'alimentation.

8. Étage d'entrée selon l'une des revendications 1 et 2, **caractérisé en ce que** les moyens de comparaison comportent une pluralité de seuils de tension (S1 à Sn) et fournissent une pluralité de bits de sortie (B1 à Bn).

9. Étage d'entrée selon la revendication 8, **caractérisé en ce que** les bits de sortie (B1 à Bn) sont représentatifs des signaux de sortie du capteur industriel lorsque celui est connecté à l'entrée (A1) de l'étage d'entrée.

## Claims

1. Input stage of a processing unit, comprising a processing circuit (3), input stage designed to be connected to an output stage of a sensor or of a controller and **characterized in that** it comprises means for biasing an input (A1) of the input stage to a bias voltage corresponding to a preset fraction of a supply voltage (Vcc), and filtering means (5) arranged between the biased input (A1) and comparison means for comparing the voltage of the biased input (A1) of the input stage with at least two voltage thresholds (S1, S2), respectively higher and lower than the bias voltage, so as to supply at least two bits (B1, B2) to the processing circuit (3).

2. Input stage according to claim 1, **characterized in that** the bias voltage (Vcc/2) is substantially equal to one half the supply voltage (Vcc).

3. Input stage according to one of claims 1 and 2, **characterized in that** the comparison means comprise two voltage thresholds (S1, S2) and supply two output bits representative of the type of output stage connected to said input (A1) of the processing unit and of the status thereof.

4. Input stage according to any one of claims 1 to 3, **characterized in that,** the output stage of the sensor or of the controller comprising an output transistor (T1, T2) having a measuring electrode connected to the biased input (A1) of the input stage of the processing unit, the output bits of the comparison means of the input stage are representative of the type of output transistor and of the status thereof.

5. Input stage according to claim 4, **characterized in that** the output transistor is of PNP or NPN type.

6. Input stage according to any one of claims 1 to 3, **characterized in that**, the output stage of the sensor or of the controller comprising an electromagnetic relay contact that is either grounded or connected to the supply voltage, the two output bits of the comparison means are representative of the type of connection of the contact and of the status thereof.

7. Input stage according to any one of claims 1 to 6, **characterized in that** the first and second voltage thresholds are respectively about two thirds and one third of the supply voltage.

8. Input stage according to one of claims 1 and 2, **characterized in that** the comparison means comprise a plurality of voltage thresholds (S1 to Sn) and supply a plurality of output bits (B1 to Bn).

9. Input stage according to claim 8, **characterized in that** the output bits (B1 to Bn) are representative of the output signals of the industrial sensor when the latter is connected to the input (A1) of the input stage.

## Patentansprüche

1. Eingangsstufe einer Verarbeitungseinheit, die eine Verarbeitungsschaltung (3) umfasst, wobei die Eingangsstufe vorgesehen ist, an eine Ausgangsstufe eines Messfühlers oder Automaten angeschlossen zu werden, und **dadurch gekennzeichnet, dass** sie Polarisierungsmittel eines Eingangs (A1) der Eingangsstufe mit einer Polarisationspannung umfasst, die einer vorbestimmten Fraktion einer Versorgungsspannung (Vcc) entspricht, sowie Filterungsmittel (5), die zwischen dem polarisierten Eingang (A1) und Vergleichsmitteln zum Vergleich der polarisierten Eingangsspannung (A1) der Eingangsstufe mit mindestens zwei Spannungsschwellenwerten (S1, S2), und zwar einem Wert, der jeweils über bzw. unter der Polarisationsspannung liegt, angeordnet sind, um der Verarbeitungsschaltung (3) mindestens 2 Bits zu liefern.

2. Eingangsstufe nach Anspruch 1, **dadurch gekennzeichnet, dass** die Polarisationsspannung (Vcc/2) im Wesentlichen gleich der halben Versorgungsspannung (Vcc) ist.

3. Eingangsstufe nach einem der Ansprüche 1 und 2, **dadurch gekennzeichnet, dass** die Vergleichsmittel zwei Spannungsschwellenwerte (S1, S2) umfassen und zwei Ausgangsbits erzeugen, die repräsentativ für den Typ der Ausgangsstufe, die an den genannten Eingang (A1) der Verarbeitungseinheit angeschlossen ist, und ihren Zustand sind.

4. Eingangsstufe nach einem der Ansprüche 1 bis 3, **dadurch gekennzeichnet, dass** wenn die Ausgangsstufe des Messfühlers oder Automaten einen Ausgangstransistor (T1, T2) umfasst, der eine Messelektrode aufweist, die an den polarisierten Eingang (A1) der Eingangsstufe der Verarbeitungseinheit gelegt ist, die Ausgangsbits der Vergleichsmittel der Eingangsstufe repräsentativ für den Typ des Ausgangstransistors und seinen Zustand sind.

5. Eingangsstufe nach Anspruch 4, **dadurch gekennzeichnet, dass** der Ausgangstransistor ein PNP- oder NPN-Transistor ist.

6. Eingangsstufe nach einem der Ansprüche 1 bis 3, **dadurch gekennzeichnet, dass**, wenn die Ausgangsstufe des Messfühlers oder Automaten einen Kontakt eines elektromagnetischen Relais umfasst, der an Masse oder die Versorgungsspannung verbunden ist, die beiden Ausgangsbits der Vergleichsmittel repräsentativ für die Art der Verbindung des Kontakts und ihren Zustand sind.

7. Eingangsstufe nach einem der Ansprüche 1 bis 6, **dadurch gekennzeichnet, dass** der erste und zweite Spannungsschwellenwert jeweils etwa 2/3 und ein Drittel der Versorgungsspannung ausmachen.

8. Eingangsstufe nach einem der Ansprüche 1 und 2, **dadurch gekennzeichnet, dass** die Vergleichsmittel eine Mehrzahl von Spannungsschwellenwerten (S1 bis Sn) umfassen und eine Mehrzahl von Ausgangsbits (B1 bis Bn) erzeugen.

9. Eingangsstufe nach Anspruch 8, **dadurch gekennzeichnet, dass** die Ausgangsbits (B1 bis Bn) repräsentativ für die Ausgangssignale des industriellen Messfühlers sind, wenn dieser an den Eingang (A1) der Eingangsstufe angeschlossen ist.
